(19) **Europäisches Patentamt**
**European Patent Office**
**Office européen des brevets**

(11) **EP 4 654 467 A1**

(12) **EUROPEAN PATENT APPLICATION**
published in accordance with Art. 153(4) EPC

(43) Date of publication:
26.11.2025 Bulletin 2025/48

(51) International Patent Classification (IPC):
H02S 50/00 (2014.01)    H02S 40/22 (2014.01)
H02S 40/32 (2014.01)    G01R 21/133 (2006.01)
H04B 17/309 (2015.01)

(21) Application number: 24781223.3

(22) Date of filing: 27.03.2024

(52) Cooperative Patent Classification (CPC):
G01R 21/133; H02S 40/22; H02S 40/32;
H02S 50/00; H04B 17/309; Y02E 10/56

(86) International application number:
PCT/KR2024/003872

(87) International publication number:
WO 2024/205233 (03.10.2024 Gazette 2024/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.03.2023 KR 20230041530

(71) Applicant: Hanwha Solutions Corporation
Jung-gu
Seoul 04541 (KR)

(72) Inventors:
• SONG, Jong Won
Seoul 04541 (KR)

• LEE, Seong Hun
Seoul 04541 (KR)
• HA, Sung Hoon
Seoul 04541 (KR)
• BAE, Jong Woo
Seoul 04541 (KR)
• YUN, Ju Hwan
Seoul 04541 (KR)

(74) Representative: Mooser, Sebastian Thomas
Wuesthoff & Wuesthoff
Patentanwälte und Rechtsanwalt PartG mbB
Schweigerstraße 2
81541 München (DE)

(54) **METHOD AND DEVICE FOR PERFORMING SAFETY FUNCTION**

(57) A processor according to an aspect: during monitoring of operation situations, determines that switching to a safety mode is needed; on the basis of the number of all devices connected to photovoltaic (PV) modules and a predefined safety voltage, identifies a target voltage of each of all the devices; and provides a shutdown signal to each of all the devices so that an output voltage of each of all the devices is controlled to the target voltage.

FIG. 1

## Description

### Technical Field

The disclosure relates to a method and device for performing a safety function.

### Background Art

Photovoltaic (PV) power generation systems are required to provide reliability by determining possible abnormalities and emergencies in real time during operation. In the event of an abnormality in a PV power generation system, the inverter is required to detect the abnormality in a very short time and take protective actions to shut down the power. In this regard, global industrial safety standards are increasingly requiring rapid shutdown (RSD) functions in PV systems.

To increase the efficiency of power generation, module-level power conversion devices (or module-level power electronics (hereinafter, referred to as "MLPEs")) are being introduced into solar power systems.

To satisfy a safety voltage required by the standards of each country, the MLPE is required to perform a safety function.

However, in a case in which passive devices, such as a resistor and a transient voltage suppressor (TVS) diode, are added to an output end of the MLPE to perform a safety function, the problem is the increased unit cost of the MLPEs. Furthermore, in a case in which the target voltage of the MLPEs is fixed, a failure in any of the MLPEs may not satisfy the safety voltage.

### Disclosure of Invention

### Technical Problem

The disclosure is intended to provide a method and device for performing a safety function. The disclosure is also intended to provide a computer-readable recording medium having recorded thereon a program for executing the method on a computer. Technical problems to be addressed are not limited to those described above, and other technical problems may exist.

### Solution to Problem

According to an aspect, provided is a processor configured to: determine whether a transition to a safety mode is necessary while monitoring an operational situation; identify a target voltage for each of total devices connected to photovoltaic (PV) modules, based on the number of the total devices and a selected safety voltage; and provide a shutdown signal to each of the total devices so that an output voltage of each of the total devices is controlled to be the target voltage.

According to another aspect, provided is a method of performing a safety function, the method including: determining whether a transition to a safety mode is necessary while monitoring an operational situation; identifying a target voltage for each of total devices connected to photovoltaic (PV) modules, based on the number of the total devices and a selected safety voltage; and providing a shutdown signal to each of the total devices so that an output voltage of each of the total devices is controlled to be the target voltage.

According to another aspect, provided is a computer-readable recording medium having recorded thereon a program for executing the above-described method on a computer.

### Advantageous Effects of Invention

The safety function may be enabled without adding any further configuration to the PV power generation system. Accordingly, the safety of the PV power generation system may be ensured and the manufacturing cost may be reduced.

Furthermore, even in a case in which a fail occurs in a group of MLPEs, safe voltage conditions may be satisfied by adjusting the target voltage. Therefore, the PV power generation system may be operated reliably.

Furthermore, methods which may be used in systems having a 1-MLPE structures as well as systems having an n-MLPE structure are provided.

### Brief Description of Drawings

FIG. 1 is a view illustrating an example photovoltaic (PV) power generation system according to embodiments.

FIG. 2 is a view illustrating an example device according to embodiments.

FIG. 3 is a flowchart illustrating an example method by which the processor according to embodiments performs a safety function.

FIG. 4 is a view illustrating a case in which a device has failed in the PV power generation system according to embodiments.

FIG. 5 is a flowchart illustrating an example in which the processor according to embodiments identifies a target voltage.

FIG. 6 is a view illustrating an example PV power generation system according to embodiments.

FIG. 7 is a view illustrating example sub-circuits of the device according to embodiments.

## Best Mode for Carrying out the Invention

A processor according to an aspect may determine whether a transition to a safety mode is necessary while monitoring an operational situation; identify a target voltage for each of total devices connected to photovoltaic (PV) modules, based on the number of the total devices and a selected safety voltage; and provide a shutdown signal to each of the total devices so that an output voltage of each of the total devices is controlled to be the target voltage.

## Mode for the Invention

Terms used in embodiments are chosen from those currently in common use, if possible, but may vary depending on the intentions of a person skilled in the art, precedents, the emergence of new technologies, and the like. Some terms may be chosen arbitrarily by the inventors, in which case the meanings of these terms will be explained in detail in appropriate parts. Therefore, the terms used in the specification should be defined based on the meanings of the terms and the context of the specification as a whole, not merely on the names of the terms.

The terms "comprise", "include", "have", and any variations thereof used herein will be understood as covering non-exclusive inclusions unless explicitly described to the contrary.

The ordinal terms, such as "first" and "second", may be used herein to describe various elements, but these elements should not be limited by these terms. These terms are used only to distinguish one element from another.

Hereinafter, example embodiments of the disclosure will be described in detail with reference to the accompanying drawings. The detailed description to be disclosed in conjunction with the accompanying drawings is intended to illustrate example embodiments of the disclosure and is not intended to represent a unique embodiment with which the disclosure may be carried out. To clearly describe the disclosure in the drawings, parts not pertinent to the description may be omitted, and the same reference numerals may be used for identical or similar elements throughout the specification.

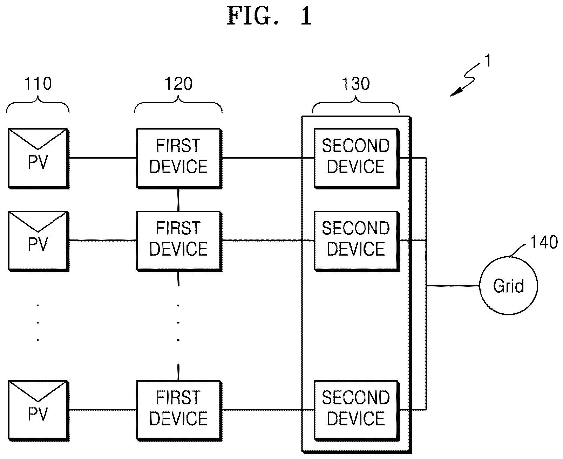

FIG. 1 is a view illustrating an example photovoltaic (PV) power generation system according to embodiments.

Referring to FIG. 1, a PV power generation system 1 includes PV modules 110, first devices 120, second devices 130, and a grid 140. The system 1 may further include general purpose components other than the components shown in FIG. 1.

The PV modules 110 are modules which generate electricity from the sunlight. For example, the system 1 may include a plurality of PV modules 110.

The first devices 120 may be connected to the PV modules 110, respectively. For example, the number of PV modules 110 and the number of first devices 120 in the system 1 may be the same.

The first devices 120 and/or the second devices 130 may be MLPEs. For example, the first devices 120 and/or the second devices 130 may be optimizers or microinverters.

In an example, in a case in which the MLPEs of the system 1 are optimizers, all of the second devices 130 of the system 1 may collectively be a single inverter. In this case, the respective first devices 120 may optimize the power output from the PV modules 110 and output the power to a single inverter (e.g., a string inverter). The current converted (e.g., converted from DC to AC) by the inverter may be output to a load or to the grid 140.

In another example, in a case in which the MLPEs of the system 1 are microinverters, the first device 120 and the second device 130 connected to a single PV module 110 may collectively be a microinverter. In other words, the first device 120 and the second device 130 may collectively be a single device. For example, the system 1 may be configured such that a single microinverter is connected to a single PV module 110. In this case, the first device 120 and the second device 130 may convert the power generated by the PV module 110. The current converted by the first device 120 and the second device 130 may be output to a load or to the grid 140.

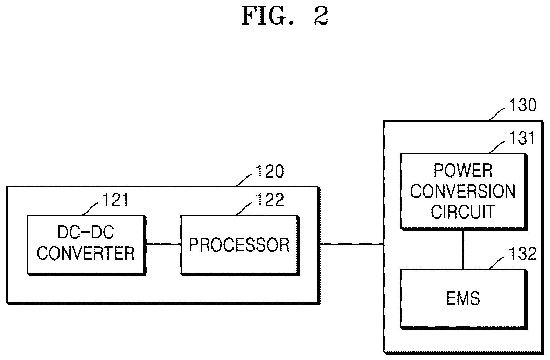

Hereinafter, the term "device" is used to refer to the first device 120 and/or the second device 130. For example, in a case in which the MLPE of the system 1 is an optimizer, the device may be the first device 120. In another example, in a case in which the MLPE of the system 1 is an optimizer, the device may be both the first device 120 and the second device 130. That is, the first device 120 and the second device 130 may collectively be a single device. An example of the first device 120 in a case in which the MLPE of the system 1 is an optimizer is described later with reference to FIG. 2.

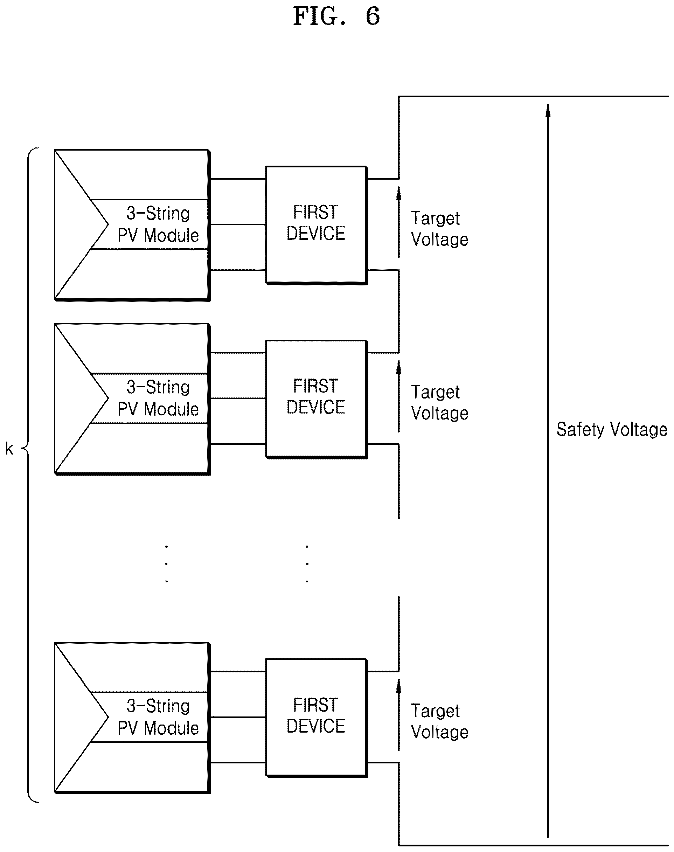

As shown in FIG. 1, a single device may be connected to, but this is not limited to, a single PV module 110. For example, depending on the structure used by the PV power generation system 1, the PV modules 110 and the devices may be provided in a many-to-one relationship or a many-to-many relationship, and the arrangement is not limited to one of the relationships. In another embodiment, the power generation system 1 may be configured such that a plurality of groups each including n number of PV modules 110 and n number of devices are connected in series (where n is a natural number greater than or equal to 2). An example of the system 1 including a plurality of groups is described later with reference to FIG. 6.

In a case in which the MLPE of the system 1 is an optimizer, the first devices 120 may be provided as a plurality of first devices 120 connected in series to each other, in which a second device 130 may be connected to each of the plurality of first devices 120 connected in series.

In a case in which the MLPE of the system 1 is an optimizer, the second device 130 may be provided in a power conversion system (PCS) to perform power conversion to supply the power generated by the PV module 110 to the load or the grid 140.

For example, the second device 130 may monitor the operational situation of the PV power generation system 1 by analyzing various data received from the PV module 110, the first device 120, the load, the grid 140, and the like. In the event of an abnormality, the second devices 130 transmit a shutdown signal to the plurality of first devices 120 to satisfy safety voltages required by standards of each country.

The disclosure proposes a PV power generation system 1 which may perform a safety function in accordance with standards based on the structure of the PV power generation system 1 in a case in which a transition to a safety mode is necessary during monitoring of the operational situation. The disclosure proposes a PV power generation system 1 which may flexibly perform a safety function in accordance with site situations, such as in a case in which some of the first devices 120 have failed or are in a fail state.

Hereinafter, the operation of the PV power generation system 1 is described in detail with reference to the drawings.

FIG. 2 is a view illustrating an example device according to embodiments.

Referring to FIG. 2, the first device 120 may include a DC-DC converter 121 and a processor 122.

For example, the DC-DC converter 121 may be implemented as a buck converter which steps down a voltage applied by the PV module 110 (i.e., an output voltage of the PV module 110). The detailed structure of the DC-DC converter 121 is not limited to any structure, and may have any design by which the output voltage of the PV module 110 may be stepped down to a desired target voltage according to a defined protocol (e.g., 30 volts or less in 30 seconds).

The processor 122 may include, for example, a power control microcontroller unit (MCU). The processor 122 may execute software, such as a program, to control at least one other component (e.g., a hardware or software component) of the first device 120, and may perform various data processing or computations.

The processor 122 may perform serial communication with the second device 130 or power line communication (PLC) to receive control signals, shutdown signals, and the like necessary for power optimization.

For example, the processor 122 may control the duty ratio of the DC-DC converter 121 to convert (or regulate) an output voltage of the first device 120.

Referring to FIG. 2, the second device 130 may include a power conversion circuit 131 and a processor 132.

For example, the power conversion circuit 131 is a circuit which converts an output voltage (DC) applied by the PV module 110 or the device module 120 to an alternating voltage (AC) for delivery to a load or the grid 140.

For example, like the processor 122, the processor 132 may be implemented as a microcontroller unit (MCU) for power control and may perform conversion control via the power conversion circuit 131 or monitor an operational situation by analyzing various data received from the PV module 110, the first device 120, the load, the grid 140, and the like. For example, the processor 132 may operate as an energy management system (EMS).

As described above with reference to FIG. 1, in a case in which the MLPE of the system 1 is a microinverter, the first device 120 and the second device 130 may collectively be a single device. In this case, the processor 122 and the processor 132 may be implemented as a single processor, or may respectively be implemented as a separate processor.

Accordingly, hereinafter, the term "device" refers to a first device 120, or a single device which is a combination of a first device 120 and a second device 130. Hereinafter, the term "processor" refers to a processor 132 or a single processor which is a combination of a processor 122 and a processor 132.

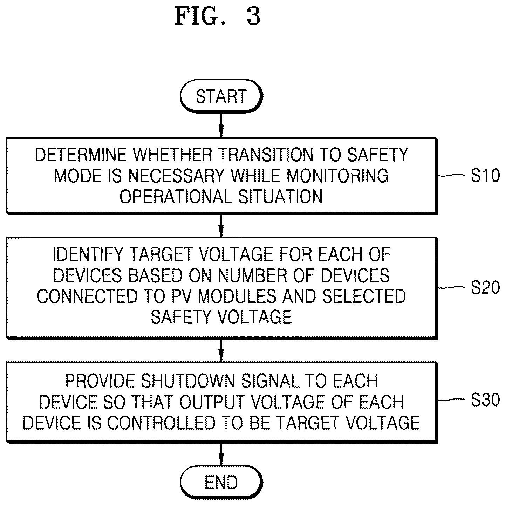

FIG. 3 is a flowchart illustrating an example method by which the processor according to embodiments performs a safety function.

Referring to operation S10, the processor determines whether a transition to a safety mode is necessary while monitoring an operational situation.

For example, the processor may monitor the operational situation of the PV power generation system 1 and identify that a transition to a safety mode is necessary.

For example, the safety mode is a mode in which the operating power of the system 1 needs to be reduced due to an abnormality in the system 1, and may be considered as a precursor to an RSD mode.

For example, the processor may identify whether a transition to a safety mode is necessary by analyzing various data received from the PV module 110, the device, the load, the grid 140, and the like. Furthermore, whether a transition to a safety mode is necessary may be identified by a variety of methods, but is not limited to one of these methods.

In operation S20, the processor is further configured to identify a target voltage for each of the devices based on the number of devices connected to the plurality of PV modules 120 and a selected safety voltage.

For example, the processor may identify a target voltage for each of the total devices based on the number of the total devices and the selected safety voltage.

For example, the number of total devices refers to the number of devices connected in series to each other, and the number of total devices may correspond to the number of cell strings of the PV module 120. Accordingly, hereinafter, the number of the total devices is used interchangeably with the number of strings.

The selected safety voltage refers to the output voltage of total devices required in the safety mode in accordance with country-specific standards. For example, the U.S.A. requires a safety voltage of 30V or less in 30 seconds in the safety mode.

In this case, it is assumed that the processor is aware of the number of strings and the safety voltage because the number of strings of the PV power generation system 1 is a structurally identified number and the national standards are also identified. For example, the processor may receive information including the number of strings and the safety voltage via a server, a main controller, or the like, or may receive a user input by which the number of strings and the safety voltage are input, and the information obtaining method is not limited to one of these methods.

The target voltage for each device is the selected safety voltage divided by the total number of strings k, as shown in Equation 1.

[Equation 1]

$$TargetVoltage = \frac{Safety\ Voltage}{k}$$

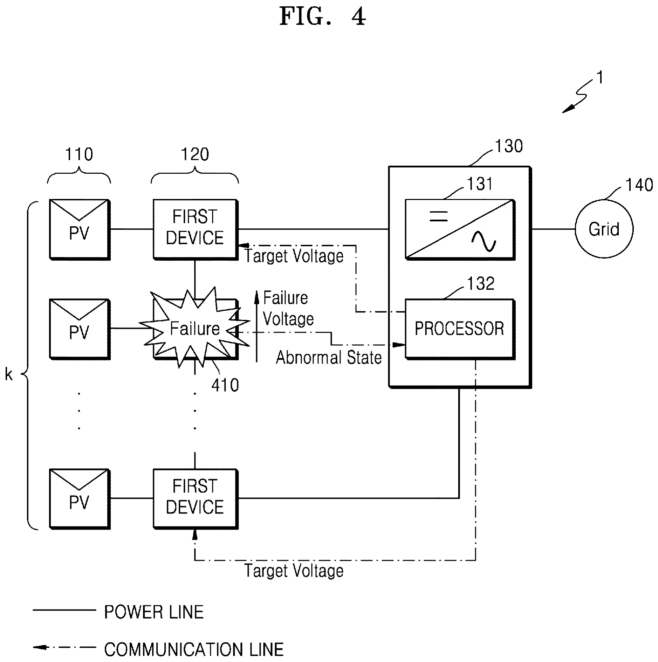

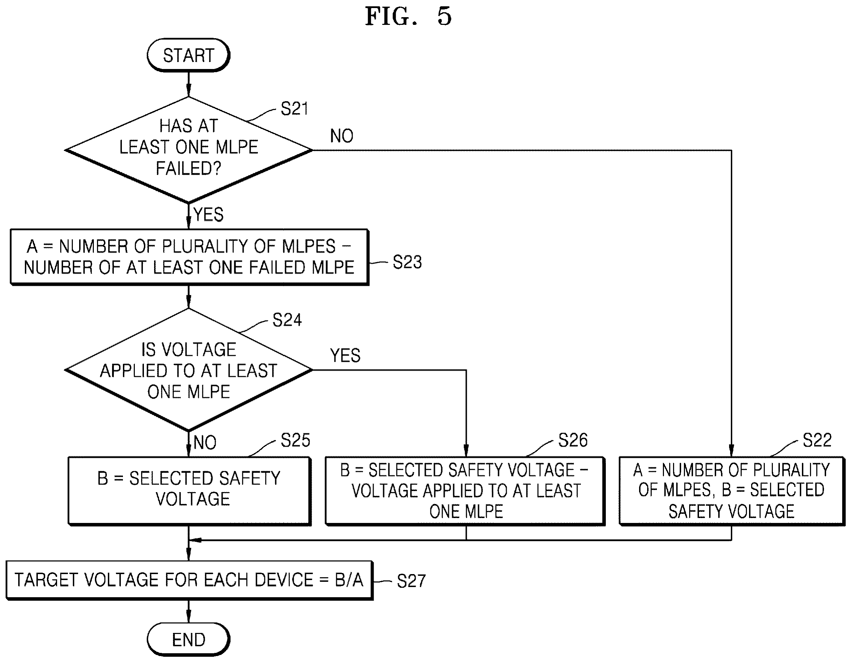

According to embodiments of the disclosure, to perform a safety function more efficiently, it is necessary to fluidly identify the target voltage for each device according to the operational situation of the device. An example in which the processor is further configured to identify the target voltage for each device according to the operational situation of the device is described later with reference to FIGS. 4 and 5.

In operation S30, the processor provides a shutdown signal to each device so that the output voltage of each device is controlled to be the target voltage.

For example, the device may control the duty ratio of the DC-DC converter 121 to optimize the output voltage of the PV module 110. In a case in which the device receives a shutdown signal, the processor may control the device to control the duty ratio of the DC-DC converter 121 so that the output voltage of the device is the target voltage.

Specifically, in a case in which the device receives a shutdown signal, the processor may control the duty ratio of the DC-DC converter using a duty ratio identified based on the output voltage Vpv of the PV module 110 and the target voltage. For example, the processor may calculate the duty ratio using Equation 2.

[Equation 2]

$$Duty\ ratio = \frac{TargetVoltage}{V_{pv}}$$

According to embodiments of the disclosure, because no additional configuration is added to the system 1, the system 1 may perform the safety function. Accordingly, the safety of the system 1 may be ensured and the manufacturing cost of the system 1 may be reduced.

FIG. 4 is a view illustrating a case in which a device has failed in the PV power generation system according to embodiments.

Referring to FIG. 4, in a case in which a transition to a safety mode is necessary, the processor 132 may transmit a shutdown signal to cause the first device 120 to reduce an output voltage to a target voltage. In this case, the processor 132 may transmit the shutdown signal to the first device 120 over a communication line.

As shown in FIG. 4, at least one first device 410 of the plurality of first devices 120 may fail. The failed first device 410 fails to control the output voltage to be the target voltage in response to the shutdown signal, which is referred to as being in a fail state or having failed.

For example, the processor 132 may identify the failed first device 410 based on a variety of configurations of the system 1 or data received from an external source. In another example, the processor 132 may receive state information from the failed first device 410. Furthermore, the process by which the processor 132 identifies whether the first device 410 is in a normal state or a fail state may be performed in a variety of manners, and is not limited to one of these manners.

To satisfy the safety voltage required in the safety mode in a case in which at least one first device 410 of the plurality of first devices 120 has failed, the remaining first devices of the plurality of first devices 120 are required to share an amount of voltage not controlled by the first device 410.

Furthermore, in a case in which a voltage higher than 0 V is applied to the failed first device 410, the target voltage for the remaining first devices is required to be reduced. A specific target voltage identification method is described below with reference to FIG. 5.

FIG. 5 is a flowchart illustrating an example in which the processor according to embodiments identifies a target voltage.

As described with reference to the operation S20 of FIG. 3 and FIG. 4, the processor may identify a target voltage for each of the devices based on the specification and site situations. FIG. 5 illustrates the operation S20 of FIG. 3 in more detail, and descriptions of some features are omitted in case that such features are the same as those in FIGS. 3 and 4.

In operation S21, the processor is further configured to identify whether at least one device has failed.

For example, the processor may obtain the target voltage in three different manners, depending on whether a device has failed and whether a voltage is applied to the failed device.

First, in a case in which none of the plurality of devices is identified as having failed (NO in operation S21), the processor is further configured to identify the number of the plurality of devices as variable A and the selected safety voltage as variable B in operation S22. In this case, A and B are the variables used to calculate the target voltage for each device in operation S27.

Thereafter, in a case in which at least one device of the plurality of devices is identified as having failed (YES in operation S21), the processor may identify the difference between the number of the plurality of devices and the number of the at least one device (i.e., the failed device) as variable A in operation S23. That is, the processor subtracts the number of the failed device from the number of the total devices.

Thereafter, the processor is further configured to identify whether a voltage is applied to at least one failed device in operation S24. In a case in which the voltage applied to the at least one failed device is zero (NO in operation S24), there is no effect on the target voltage. In this case, the processor may identify the selected safety voltage as variable B in operation S25. Here, in a case in which a plurality of devices have failed, the processor is further configured to identify the selected safety voltage as variable B only in a case in which the voltage applied to all devices in a normal state is zero.

In a case in which a voltage (having a level greater than 0 V and referred to as a first voltage) is applied to at least one failed device (YES in operation S24), the processor may identify the difference between the selected safety voltage and the first voltage applied to the at least one device as variable B in operation S26. Here, in a case in which a plurality of devices have failed, the processor considers the sum of the voltages applied to all the failed devices as the first voltage. That is, the processor subtracts from the safety voltage a voltage fixedly applied to the device due to a failure.

Finally, the processor may identify the target voltage for each of the devices using variables A and B identified by the three cases in operation S27.

For example, a method of obtaining the target voltage using the variables of operation S22 may be represented by Equation 1, and a method of obtaining the target voltage using the variables of operation S25 may be represented by Equation 3.

$$[\text{Equation 3}]$$

$$TargetVoltage = \frac{Safety\ Voltage}{k\text{-}Number\ of\ Failure}$$

(Safety Voltage: selected safety voltage, k: number of a plurality of devices, and Number of Failure: number of failed devices)

Similarly, a method of obtaining the target voltage using the variables of operation S26 may be represented by Equation 4.

$$[\text{Equation 4}]$$

$$TargetVoltage = \frac{Safety\ Voltage - Failure\ Voltage}{k - Number\ of\ Failure}$$

(Safety Voltage: selected safety voltage, Failure Voltage: voltage applied to failed devices, k: number of a plurality of devices, Number of Failure: number of failed devices)

According to embodiments of the disclosure, processor instructions at a higher level of the system allow for flexible response in accordance with safety standards required for each country and module mounting site conditions.

According to embodiments of the disclosure, even in a case in which a device fails, the safety voltage condition may be satisfied by adjusting the target voltage, and therefore reliability is obtained.

FIG. 6 is a view illustrating an example PV power generation system according to embodiments.

As described above with reference to FIG. 1, the system 1 may be configured such that a plurality of groups each including n number of PV modules and n number of devices are connected in series (where n is a natural number greater than or equal to 2).

The processor may identify a target voltage for each of the groups, and the same as described above with reference to FIGS. 3 to 5 may be applied to a basic target voltage identification process.

However, as shown in FIG. 6, the target voltage identified corresponds to the target voltage for each of the groups. Therefore, in a case in which any of the devices in each group fails, target voltages required among the devices in the group need to be adjusted.

For example, in a case in which the processor is further configured to identify at least one failed device out of n number of devices in each group, the processor may identify a target voltage for the remaining devices in each group using the difference between n and the number of at least one failed device. Expressed mathematically, this is the same as Equation 3, except that k is replaced by n because the unit is the group.

Furthermore, in a case in which a voltage (having a level greater than 0 V and referred to as a second voltage) is applied to a failed device in each group, the processor may identify the target voltage for the remaining devices using the difference between the target voltage for each group and the second voltage. Expressed mathematically, this is the same as Equation 4, in which k is replaced by n because the unit is the group.

In a case in which all of the devices in any group have failed, none of Equations 3 and 4 is applied, and the target voltage for each group is re-identified based on whether or not a voltage is applied to the corresponding group.

Referring to FIG. 6, the PV power generation system includes a plurality of groups each including three PV modules and three devices. The processor distributes target voltages to the respective groups according to the safety voltage required for the system.

According to embodiments of the disclosure, even in a case in which any of devices in a group fails, the processor may adjust the target voltage to satisfy the safety voltage condition.

According to embodiments of the disclosure, the safety function may be applied to a system extended to an n-device structure as well as a 1-device structure.

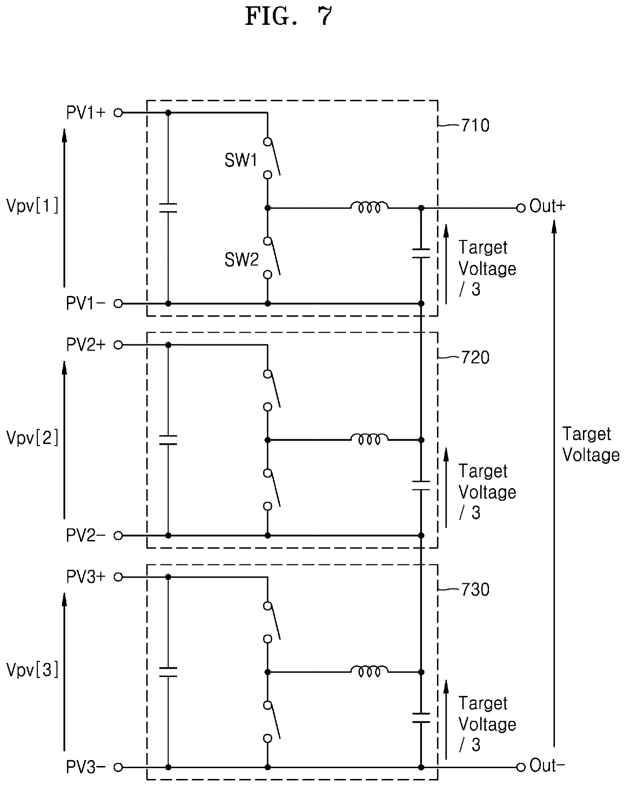

Hereinafter, sub-circuits of a 3-device system are described with reference to FIG. 7.

FIG. 7 is a view illustrating example sub-circuits of the device according to embodiments.

Referring to FIG. 7, three devices 710, 720, and 730 included in a group are shown. The three devices 710, 720, and 730 share a target voltage required for the group by each taking one-third of the target voltage.

Sub-circuits of the devices 710, 720, and 730 are implemented in the form of DC-DC converters, and each of the devices 710, 720, and 730 controls the duty ratio of the DC-DC converter to reduce an applied output voltage Vpv of a PV module to the target voltage/3, i.e., one-third of the target voltage. The duty ratio is calculated in the same manner as described above using Equation 2. In this case, the target voltage of Equation 2 is replaced by the target voltage/3.

As described above with reference to FIG. 6, in a case in which any of the devices 710, 720, and 730 fails, target voltages required among the devices in the group may need to be adjusted.

For example, in a case in which a device 720 has failed, the processor may identify the device 710 and the device 730 by adjusting the target voltage from the target voltage/3 to the target voltage/2. Here, in a case in which a second voltage is applied to the device 720, the processor may identify the device 710 and the device 730 by adjusting the target voltage from the target voltage/3 to the (target voltage - second voltage)/2. For example, the processor may use Equation 3 and Equation 4.

According to embodiments of the disclosure, the processor may adjust the voltage only for a group including a failed device, thereby reducing a computational process and speeding up the performance of the safety function.

The method described above may be constructed as a program executable on a computer, and may be implemented on a general purpose digital computer which runs the program using a computer-readable recording medium. Furthermore, the data structure used in the method described above may be recorded on the computer-readable recording medium by various means. The computer-readable recording medium includes storage media such as magnetic storage media (e.g., ROM, RAM, USB, floppy disk, and hard disk), optical reading media (e.g., CD-ROM and DVD), and the like.

A person having ordinary knowledge in the art to which the embodiments pertain will appreciate that various modifications are possible without departing from the essential features of the disclosure. The methods disclosed are therefore to be considered in an illustrative, not a limiting, perspective, and the scope of the right is to be construed as being

# EP 4 654 467 A1

defined by the claims, but by the foregoing description, and to encompass all equivalent differences.

## Claims

1. A processor configured to:

   determine whether a transition to a safety mode is necessary while monitoring an operational situation;
   identify a target voltage for each of total devices connected to photovoltaic (PV) modules, based on the number of the total devices and a selected safety voltage; and
   provide a shutdown signal to each of the total devices so that an output voltage of each of the total devices is controlled to be the target voltage.

2. The processor of claim 1,
   wherein in a case in which at least one device of the total devices is identified as having failed, the processor is further configured to identify the target voltage for each of the total devices using a difference between the number of the total devices and the number of the at least one failed device.

3. The processor of claim 2,

   wherein the processor
   is further configured to identify the target voltage for each of the total devices based on whether a voltage is applied to the at least one failed device.

4. The processor of claim 3,
   wherein in a case in which a first voltage is applied to the at least one failed device, the processor is further configured to identify the target voltage for each of the total devices using a difference between the safety voltage and the first voltage.

5. The processor of claim 1,

   wherein the PV modules and the total devices
   comprise a plurality of groups each comprising n number of PV modules and n number of devices, where n is a natural number greater than or equal to 2, and
   the processor is further configured to:

   identify a target voltage for each of the plurality of groups; and
   in a case in which at least one device of the n number of devices included in each of the groups is identified as having failed, identify a target voltage for remaining devices included in each of the groups using a difference between the n and the number of the at least one failed device.

6. The processor of claim 5,
   wherein in a case in which a second voltage is applied to the at least one failed device, the processor is further configured to identify the target voltage for the remaining devices using a difference between the target voltage for each of the groups and the second voltage.

7. The processor of claim 1,
   wherein in a case in which each of the total devices receives the shutdown signal, the processor is further configured to control a duty ratio of a DC-DC converter using a duty ratio identified based on output voltages of the PV modules connected to the total devices, respectively, and the target voltage.

8. A method of performing a safety function, the method comprising:

   determining whether a transition to a safety mode is necessary while monitoring an operational situation;
   identifying a target voltage for each of total devices connected to photovoltaic (PV) modules, based on the number of the total devices and a selected safety voltage; and
   providing a shutdown signal to each of the total devices so that an output voltage of each of the total devices is controlled to be the target voltage.

9. The method of claim 8,
wherein in a case in which at least one device of the total devices is identified as having failed, the identifying includes identifying the target voltage for each of the total devices using a difference between the number of the total devices and the number of the at least one failed device.

10. The method of claim 9,

wherein in the identifying,
the target voltage for each of the total devices is identified based on whether a voltage is applied to the at least one failed device.

11. The method of claim 10,
wherein in a case in which a first voltage is applied to the at least one failed device, the identifying includes identifying the target voltage for each of the total devices using a difference between the safety voltage and the first voltage.

12. The method of claim 9,

wherein the PV modules and the total devices
comprise a plurality of groups each comprising n number of PV modules and n number of devices, where n is a natural number greater than or equal to 2, and
the method further comprises:

identifying a target voltage for each of the plurality of groups; and
in a case in which at least one device of the n number of devices included in each of the groups is identified as having failed, identifying a target voltage for remaining devices included in each of the groups using a difference between the n and the number of the at least one failed device.

13. The method of claim 12,
wherein in a case in which a second voltage is applied to the at least one failed device, the identifying a target voltage for remaining devices includes identifying the target voltage for the remaining devices using a difference between the target voltage for each of the groups and the second voltage.

14. The method of claim 8,
further comprising, in a case in which each of the total devices receives the shutdown signal, controlling a duty ratio of a DC-DC converter using a duty ratio identified based on output voltages of the PV modules connected to the total devices, respectively, and the target voltage.

15. A computer-readable recording medium having recorded thereon a program for causing a computer to execute the method of claim 8.

# FIG. 1

FIG. 2

# FIG. 3

START

DETERMINE WHETHER TRANSITION TO SAFETY MODE IS NECESSARY WHILE MONITORING OPERATIONAL SITUATION — S10

IDENTIFY TARGET VOLTAGE FOR EACH OF DEVICES BASED ON NUMBER OF DEVICES CONNECTED TO PV MODULES AND SELECTED SAFETY VOLTAGE — S20

PROVIDE SHUTDOWN SIGNAL TO EACH DEVICE SO THAT OUTPUT VOLTAGE OF EACH DEVICE IS CONTROLLED TO BE TARGET VOLTAGE — S30

END

# FIG. 4

1

110    120                                    130

                                              131

PV ─── FIRST DEVICE ──────────────── [= / ~] ──── Grid    140

                    Target Voltage

PV ─── {Failure} ↑ Failure Voltage          132

                    Abnormal State    PROCESSOR

k {

    410

PV ─── FIRST DEVICE

                    Target Voltage

─────── POWER LINE

◄ ─ · ─ COMMUNICATION LINE

# FIG. 5

START

↓

HAS AT LEAST ONE MLPE FAILED? — S21

NO →

YES ↓

A = NUMBER OF PLURALITY OF MLPES − NUMBER OF AT LEAST ONE FAILED MLPE — S23

↓

IS VOLTAGE APPLIED TO AT LEAST ONE MLPE — S24

YES →

NO ↓ — S25

B = SELECTED SAFETY VOLTAGE

B = SELECTED SAFETY VOLTAGE − VOLTAGE APPLIED TO AT LEAST ONE MLPE — S26

A = NUMBER OF PLURALITY OF MLPES, B = SELECTED SAFETY VOLTAGE — S22

↓

TARGET VOLTAGE FOR EACH DEVICE = B/A — S27

↓

END

EP 4 654 467 A1

# FIG. 6

# FIG. 7

## INTERNATIONAL SEARCH REPORT

| International application No. |
|---|
| **PCT/KR2024/003872** |

### A. CLASSIFICATION OF SUBJECT MATTER

**H02S 50/00**(2014.01)i; **H02S 40/22**(2014.01)i; **H02S 40/32**(2014.01)i; **G01R 21/133**(2006.01)i; **H04B 17/309**(2015.01)i

According to International Patent Classification (IPC) or to both national classification and IPC

### B. FIELDS SEARCHED

Minimum documentation searched (classification system followed by classification symbols)

H02S 50/00(2014.01); H01L 31/02(2006.01); H01L 31/042(2006.01); H01L 31/05(2006.01); H02J 3/38(2006.01); H02S 40/34(2014.01); H02S 50/10(2014.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 태양광(solar), 안전(safety), 셧 다운(shutdown), 타겟전압(target), 비정상(abnormal)

### C. DOCUMENTS CONSIDERED TO BE RELEVANT

| Category* | Citation of document, with indication, where appropriate, of the relevant passages | Relevant to claim No. |
|---|---|---|
| X | KR 10-2018-0067433 A (TOYOTA JIDOSHA KABUSHIKI KAISHA) 20 June 2018 (2018-06-20) See paragraphs [0025]-[0031] and [0092]-[0093] and figure 9. | 1-2,5,7-9,12,14-15 |
| Y | | 3-4,6,10-11,13 |
| Y | KR 10-2019-0125149 A (BEIJING HANERGY SOLAR POWER INVESTMENT CO., LTD.) 06 November 2019 (2019-11-06) See paragraph [0064] and figure 2. | 3-4,6,10-11,13 |
| A | KR 10-2018-0072244 A (GRAND CO., LTD.) 29 June 2018 (2018-06-29) See claims 1-10 and figure 2. | 1-15 |
| A | JP 2021-002930 A (PANASONIC IP MANAGEMENT CORP.) 07 January 2021 (2021-01-07) See entire document. | 1-15 |

☑ Further documents are listed in the continuation of Box C.  ☑ See patent family annex.

\*  Special categories of cited documents:
"A"  document defining the general state of the art which is not considered to be of particular relevance
"D"  document cited by the applicant in the international application
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
|---|---|
| **01 July 2024** | **01 July 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/003872** |

### C. DOCUMENTS CONSIDERED TO BE RELEVANT

| Category* | Citation of document, with indication, where appropriate, of the relevant passages | Relevant to claim No. |
| --- | --- | --- |
| A | EP 3242331 A1 (SHINE CHARM LIMITED) 08 November 2017 (2017-11-08)<br>See entire document. | 1-15 |

Form PCT/ISA/210 (second sheet) (July 2022)

**INTERNATIONAL SEARCH REPORT**
Information on patent family members

International application No.

**PCT/KR2024/003872**

| Patent document cited in search report | | | Publication date (day/month/year) | Patent family member(s) | | | Publication date (day/month/year) |
|---|---|---|---|---|---|---|---|
| KR | 10-2018-0067433 | A | 20 June 2018 | BR | 102017026507 | A2 | 17 July 2018 |
| | | | | BR | 102017026507 | B1 | 11 April 2023 |
| | | | | CA | 2988232 | A1 | 12 June 2018 |
| | | | | CA | 2988232 | C | 22 October 2019 |
| | | | | CN | 108233514 | A | 29 June 2018 |
| | | | | CN | 108233514 | B | 15 January 2021 |
| | | | | EP | 3333665 | A1 | 13 June 2018 |
| | | | | EP | 3333665 | B1 | 17 February 2021 |
| | | | | JP | 2018-098880 | A | 21 June 2018 |
| | | | | JP | 6536552 | B2 | 03 July 2019 |
| | | | | KR | 10-1980456 | B1 | 30 August 2019 |
| | | | | MY | 186150 | A | 28 June 2021 |
| | | | | RU | 2666123 | C1 | 10 September 2018 |
| | | | | TW | 201827765 | A | 01 August 2018 |
| | | | | TW | I649524 | B | 01 February 2019 |
| | | | | US | 10476274 | B2 | 12 November 2019 |
| | | | | US | 2018-0166882 | A1 | 14 June 2018 |
| KR | 10-2019-0125149 | A | 06 November 2019 | AU | 2018-214063 | A1 | 14 November 2019 |
| | | | | CN | 110417348 | A | 05 November 2019 |
| | | | | CN | 208424310 | U | 22 January 2019 |
| | | | | EP | 3561987 | A1 | 30 October 2019 |
| | | | | JP | 2019-193550 | A | 31 October 2019 |
| | | | | US | 2019-0334473 | A1 | 31 October 2019 |
| | | | | WO | 2019-205289 | A1 | 31 October 2019 |
| KR | 10-2018-0072244 | A | 29 June 2018 | None | | | |
| JP | 2021-002930 | A | 07 January 2021 | None | | | |
| EP | 3242331 | A1 | 08 November 2017 | CA | 2953448 | A1 | 03 November 2017 |
| | | | | CN | 105720913 | A | 29 June 2016 |
| | | | | JP | 2017-201868 | A | 09 November 2017 |
| | | | | KR | 10-2017-0124945 | A | 13 November 2017 |
| | | | | US | 2017-0324371 | A1 | 09 November 2017 |

Form PCT/ISA/210 (patent family annex) (July 2022)